Europäisches Patentamt

European Patent Office

Office européen des brevets

(11) Veröffentlichungsnummer: **0 353 406**
**A1**

## (12) EUROPÄISCHE PATENTANMELDUNG

(21) Anmeldenummer: **89108573.0**

(22) Anmeldetag: **12.05.89**

(51) Int. Cl.⁴: **H03K 17/10 , H03K 17/08 , H03F 3/217**

(30) Priorität: **07.07.88 DE 3822991**

(43) Veröffentlichungstag der Anmeldung:
**07.02.90 Patentblatt 90/06**

(84) Benannte Vertragsstaaten:
**CH DE FR GB LI**

(71) Anmelder: **AEG Olympia Aktiengesellschaft**
**Postfach 960**
**D-2940 Wilhelmshaven(DE)**

(72) Erfinder: **Zeiss, Jürgen, Dipl.-Ing. (FH)**
**Tutzinger Strasse 19**
**D-1000 Berlin 49(DE)**

(74) Vertreter: **Vogl, Leo, Dipl.-Ing.**
**AEG Olympia Aktiengesellschaft**
**Theodor-Stern-Kai 1**
**D-6000 Frankfurt 70(DE)**

(54) **Hochspannungsschalter.**

(57) Hochspannungsschalter mit mehreren in Reihe geschalteten und mit Steuerimpulsen einer Steuerschaltung synchron angesteuerten Halbleiterschaltern (10-40, 11-41, 1N-4N). Die Halbleiterschalter sind in Gruppen zusammengefaßt. Zu jeder Gruppe führt jeweils nur eine Steuerleitungen (ST10, ST11, ST1N) der galvanisch von den Halbleiterschaltern getrennten Steuerschaltung (S).

FIG.1

EP 0 353 406 A1

# Hochspannungsschalter

Die Erfindung betrifft einen Hochspannungsschalter gemäß dem Oberbegriff des Patentanspruchs 1. Ein solcher Hochspannungsschalter ist beispielsweise aus der EP-A1-0 048 758 bekannt.

Der bekannte Hochspannungsschalter dient zum Schalten von Gleichspannungen und besteht aus mehreren in Reihe geschalteten Halbleiterschaltern (hier: MOS-Feldeffekttransistoren/oder MOSFET), die mit Steuerimpulsen einer Steuerschaltung synchron angesteuert, d.h. ein- und ausgeschaltet werden. Zur Übertragung der Steuerimpulse ist jeder der Halbleiterschalter über eine ihm zugeordnete und an seine Steuerelektrode angeschlossene Steuerleitung mit der Steuerschaltung verbunden. Zur galvanischen Trennung der Steuerschaltung von den Halbleiterschaltern ist ein Im-pulsübertrager vorgesehen mit einer steuerschal-tungsseitigen Primärwicklung und einer der Zahl der Halbleiterschalter entsprechenden Zahl von Sekundärwicklungen, an die jeweils die einzelnen Steuerleitungen angeschlossen sind.

Eine galvanische Trennung von Steuerschaltung und Halbleiterschalter ist grundsätzlich aus Sicherheitsgründen empfehlenswert; sie ist i.a. erforderlich, um Gleichspannungen unterschiedlicher Polarität schalten zu können. Auch der Einsatz in Gegentakt- oder Brückenschaltungen erfordert diese galvanische Trennung.

Nachteilig bei dieser bekannten Lösung ist, daß die Scheinwiderstände der einzelnen Sekundärwicklungen mit der Belastung des Impulsübertragers, d.h. mit der Anzahl der angeschlossenen MOSFETs anwachsen, was zur Folge hat, daß die Einschaltzeiten des Hochspannungsschalters entsprechend anwachsen, da die Schaltzeit eines MOSFETs im wesentlichen durch seine Eingangskapazität und durch die Impedanz seiner Steuerspannungsquelle festgelegt wird. Nachteilig wirkt sich außerdem noch aus, daß insbesondere bei Gleichspannungen im kV-Bereich eine aufwendige Isolation der einzelnen Wicklungen des Impulsübertragers erforderlich ist.

Die der Erfindung zugrunde liegende Aufgabe besteht darin, einen Hochspannungsschalter der eingangs genannten Art zu schaffen, der mit möglichst wenig Ansteuerungsaufwand realisiert werden kann.

Die erfindungsgemäße Lösung der Aufgabe ist im Patentanspruch 1 beschrieben. Die übrigen Ansprüche enthalten vorteilhafte Aus- und Weiterbil-dungen des erfindungsgemäßen Hochspannungs-schalters sowie bevorzugte Anwendungen der Erfindung.

Die erfindungsgemäße Lösung besteht darin, daß die in Reihe geschalteten Halbleiterschalter in Gruppen zusammengefaßt werden und daß zu jeder Gruppe jeweils nur eine Steuerleitung führt, über die die in der Steuerschaltung erzeugten Steuerimpulse übertragen werden, wodurch sich der Ansteuerungsaufwand entsprechend verringert.

Zur Realisierung des erfindungsgemäßen Hochspannungsschalters werden jeweils mehrere Halbleiterschalter in Reihe geschaltet, wobei sich die Zahl der in Reihe zu schaltenden Halbleiterschalter aus dem Verhältnis der zulässigen Sperrspannung der verwendeten Bauelemente zu der zu schaltenden Hochspannung ergibt. Gegebenenfalls müssen diesen Halbleiterschalter weitere Halbleiterschalter parallel geschaltet werden, wobei sich die Zahl der parallel zu schaltenden Halbleiterschalter aus dem Verhältnis des zulässigen Durchlaßstromes der verwendeten Bauelemente zu dem zu schaltenden Gesamtstrom ergibt.

Als Halbleiterschalter kommen derzeit beispielsweise MOS-Feldeffekttransistoren (MOSFET) oder Static-Induction-Transistoren (SIT) in Betracht.

Von den derzeit verfügbaren Bauelementen sind MOSFET am günstigsten, da sich mit ihnen sehr kurze Schaltzeiten erreichen lassen. Außerdem entfallen bei ihnen die für bipolare Bauelemente typischen Speicherzeiten. Ferner ist die Pa-rallelschaltung mehrerer MOSFETs unproblema-tisch, da sie im Gegensatz Bipolartransistoren einen negativen Temperaturgradienten aufweisen, der dazu führt, daß der Durchlaßwiderstand eines MOSFETs mit steigender Temperatur zunimmt und der Durchlaßstrom entsprechend abnimmt, so daß sich der gesamte Strom automatisch gleichmäßig auf die parallel geschalteten Bauelemente aufteilt und eine Überbelastung einzelner Bauelemente dadurch vermieden wird.

In einer vorteilhaften Ausführungsform der erfindungsgemäßen Lösung werden in den einzelnen Gruppen mit den in Reihe geschalteten Halbleiter-Schaltern vorzugsweise jeweils der potentialmäßig am niedrigsten liegende Halbleiterschalter über Lichtleitkabel, Trägerfrequenz oder mit Nadelimpulsen angesteuert und die übrigen Halbleiterschalter durch eine erfindungsgemäße RC-Beschaltung angesteuert. Zur Erhöhung der Zuverlässigkeit wird dabei vorteilhafterweise die Funktion des potentialmäßig obersten Halbleiterschalter jeder Gruppe überwacht, da bei Ausfall eines Halbleiterschalters innerhalb einer Gruppe der potentialmäßig oberste immer mit betroffen ist.

Im folgenden wird die Erfindung anhand der Figuren näher erläutert. Es zeigen:

FIG. 1 ein Blockschaltbild des erfindungsgemäßen Hochspannungsschalters

FIG. 2-7 verschiedene Konfigurationen des erfindungsgemäßen Hochspannungsschalters gemäß FIG. 1

FIG. 8-12 verschiedene erfindungsgemäße Ansteuerungen für den erfindungsgemäßen Hochspannungsschalter gemäß FIG. 1 mit in Reihe geschalteten MOS-Feldeffekttrasistoren

FIG. 13-15 drei verschiedene erfindungsgemäße Überwachungsschaltungen für die gemäß den Figuren 8-12 in Reihe geschalteten MOSFETs.

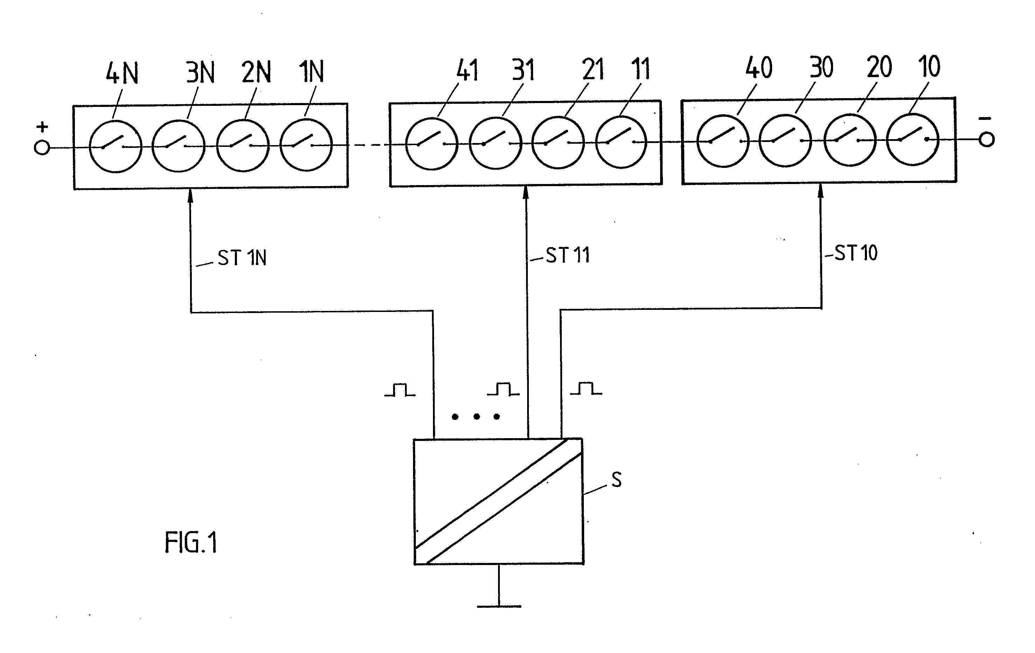

Der erfindungsgemäße Hochspannungsschalter in FIG. 1 besteht aus mehreren Gruppen (10, 20, 30, 40) (11, 21, 31, 41),....., (1N, 2N, 3N, 4N) von beispielhaft jeweils vier in Reihe geschalteten Halbleiterschaltern. Zu jeder dieser Gruppen führt eine Steuerleitung ST10-ST1N, über die Steuerimpulse der Steuerschaltung S übertragen werden.

Wegen der hohen Spannungen ist es vielfach zwingend erforderlich, die Steuerschaltung S galvanisch von dem Hochspannungsschalter in FIG. 1 zu trennen. Dies kann beispielsweise dadurch geschehen, daß in den einzelnen Steuerleitungen ST10-ST1N von der Steuerschaltung S zu den Halbleiterschaltern bzw. Halbleiterschalter-Gruppen Impulsübertrager eingebaut werden. Eine andere gängige Methode ist die Übertragung der Steuerimpulse über Lichtleitkabel, wobei i.a. an den beiden Enden des Kabels jeweils ein elektrooptischer Wandler angebracht ist, mit dem die elektrischen Steuersignale in optische Steuersignale umge wandelt werden bzw. umgekehrt die optischen Steuerimpulse wieder in elektrische.

In Anwendungen, in denen der Hochspannungsschalter als "Zerhacker" einer ersten Gleichspannung eingesetzt wird, um mit der "zerhackten" Gleichspannung in einen nachgeschalteten Tiefpaßfilter eine zweite statisch oder dynamisch variabel einstellbare Gleichspannung zu gewinnen, werden die Halbleiterschalter synchron, d.h. zeitgleich vorzugsweise mit pulsdauermodulierten Impulsfolgen angesteuert (d.h. mit Impulsfolgen konstanter Schaltfrequenz und variabler Impulsdauer). Möglich ist auch die Ansteuerung mit pulsfrequenzmodulierten Impulsfolgen (d.h. mit Impulsfolgen konstanter Impulsdauer und variabler Schaltfrequenz (= Anzahl der Impulse pro Zeiteinheit)).

Die in FIG. 1 gezeigte Grundschaltung von in Reihe geschalteten Halbleiterschaltern kann auf vielfältige Art und Weise aus- und weitergebildet werden bzw. an die unterschiedlichen Anwendungen angepaßt werden.

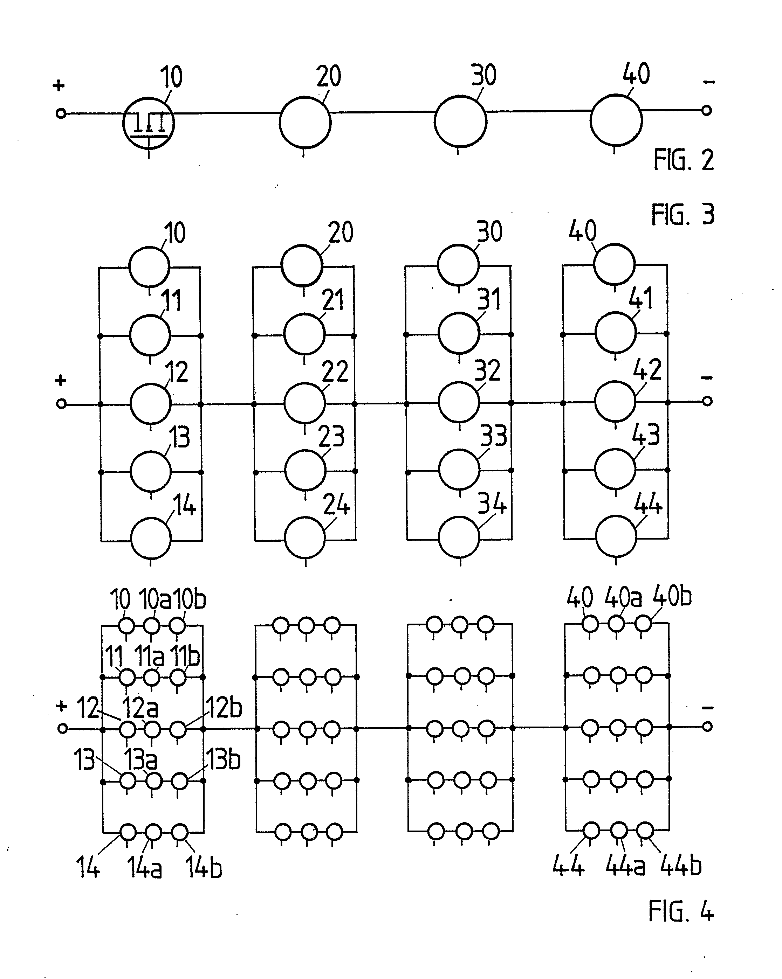

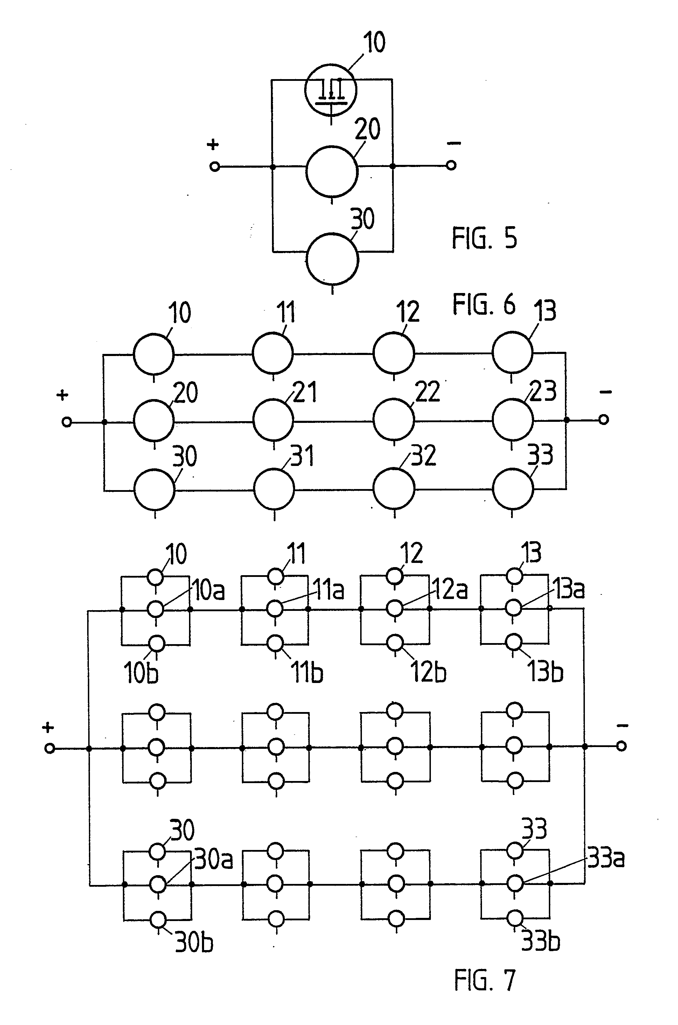

Aus den beiden Grundschaltungen mehrer in Reihe geschalteter Halbleiterschalter oder mehrer parallel geschalteter Halbleiterschalter, wie sie in den Figuren 2 und 5 beispielhaft anhand von vier in Reihe bzw. drei parallel geschalteten Bauelementen 10-40 bzw. 10-30 gezeigt sind, lassen sich eine Reihe von Konfigurationen ableiten, die aus Gruppen in Reihe oder parallel geschalteter Halbleiterschalter bestehen, wie z.B. die Konfigurationen in den Figuren 3 und 4, die aus der Reihenschaltung der FIG. 2 abgeleitet sind, oder die in den Figuren 6 und 7, die aus der Parallelschaltung der FIG. 5 abgeleitet sind. In allen Figuren 2-7 sind die einzelnen Halbleiterschalter durch Kreise dargestellt, wobei jeweils ein Kreis in den Figuren 2 und 5 stellvertretend für alle anderen Kreise mit den Schaltzeichen eines MOSFETs ausgefüllt ist, was jedoch nur als allgemeines Symbol für einen Halbleiterschalter verstanden werden soll.

In FIG. 3 wurde jedem Halbleiterschalter 10-40 der FIG. 2 beispielhaft jeweils vier weitere Schalter 11-14; 21-24; 31-34; 41-44 parallel geschaltet, in FIG. 4 jedem der Halbleiterschalter 10-14; 20-24; 30-34; 40-44 der FIG. 3 beispielhaft jeweils zwei weitere Schalter 10a, b; 11a, b; ..44a, b in Reihe geschaltet. In FIG. 6 wurden jedem Halbleiterschalter 10-30 der FIG. 5 beispielhaft jeweils drei weitere Schalter 11-13; 21-23; 31-33 in Reihe geschaltet, in FIG. 7 jedem der Halbleiterschalter 10-13; 20-23; 30-33 der FIG. 6 beispielhaft jeweils zwei weitere Schalter 10a, b; 11a, b; ...33a, b parallelgeschaltet. Andere Konfigurationen sind selbstverständlich auch möglich.

Welche Schalterkonfiguration für den Aufbau des Hochspannungsschalters tatsächlich geeignet ist, hängt natürlich von den übrigen Randbedingungen der jeweiligen Anwendung ab.

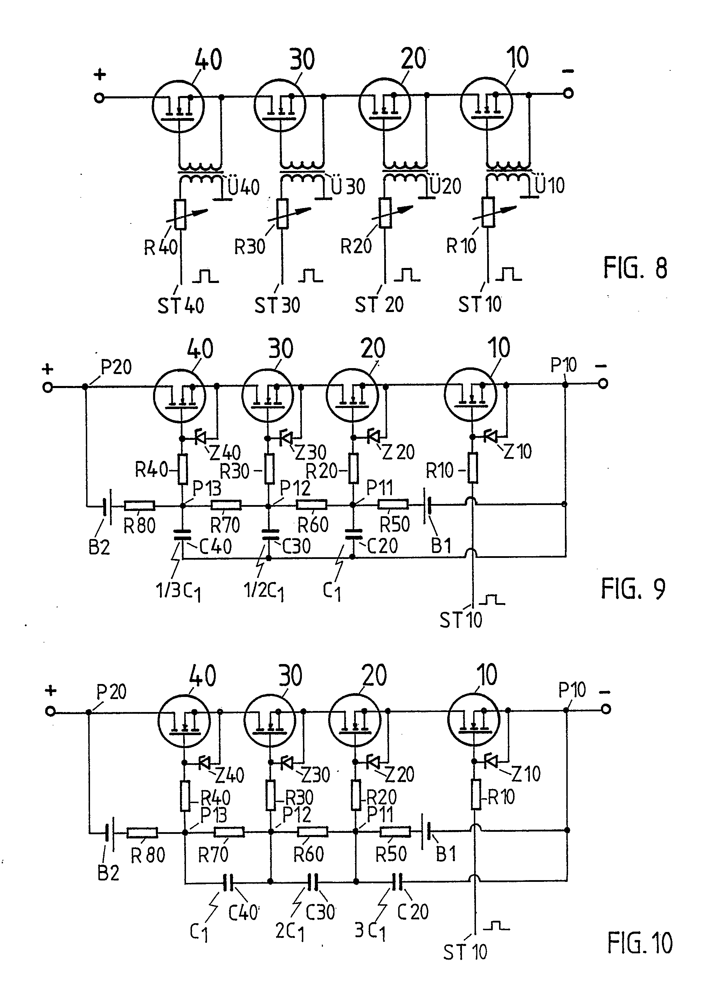

Bevorzugte Ausführungsformen der erfindungsgemäßen Ansteuerungen für Gruppen von in Reihe geschaltete MOSFETs sind in den Figuren 8- 12 gezeigt.

In Figur 8 ist beispielhaft eine Gruppe von vier in Reihe geschalteten MOSFETs 10-40 gezeigt. Jeder dieser MOSFETs 10-40 ist mit seiner Gate-Elektrode in an sich aus der EP-A1-0 048 758 bekannter Weise an eine ihm zugeordnete Steuerleitung ST10-ST40 angeschlossen. Zur galvanischen Trennung ist dabei jeweils ein Übertrager, vorzugsweise ein Ringkern-Übertrager Ü10-Ü40 in den Steuerleitungen ST10-ST40 vorgesehen, dessen Sekundärwicklung mit dem einem Ende an die Gate-Elektrode und mit dem anderen Ende an die Source-Elektrode des zugeordneten MOSFETs 10-40 angeschlossen ist und dessen Primärwicklung mit dem einen Ende an Masse und mit dem anderen Ende an die zugeordnete Steuerleitung ST10-ST40 angeschlossen ist. Zur Einstellung der Sperrspannungsaufteilung zwischen den einzelnen MOSFETs 10-40 ist in jeder Steuerleitung ST10-ST40 zusätzlich noch ein in seinem Wert variabel einstellbarer Widerstand R10-R40 eingebaut, der in Reihe mit der Primärwicklung des zugeordneten Übertragers Ü10-Ü40 liegt.

Zur Synchronisierung der Schaltzeitpunkte der einzelnen MOSFETs 10-40 kann außerdem noch in jeder Steuerleitung ST10-ST40 ein (in der Figur nicht gezeigtes) variabel einstellbares Zeitverzögerungsglied eingebaut werden, daß vorzugsweise ebenfalls mit der Primärwicklung des zugeordneten Übertragers Ü10-Ü40 in Reihe geschaltet ist.

Mit einer solchen Ansteuerung wird eine sehr gleichmäßige Sperrspannungsaufteilung zwischen den einzelnen MOSFETs erreicht. Auch sind die Schaltzeitpunkte der einzelnen MOSFETs mit dieser Ansteuerung gut zu synchronisieren, so daß kurze Schaltzeiten des Hochspannungsschalters realisierbar sind. Schließlich kann mit dieser Schaltung die störende Restspannung an den durchgeschalteten MOSFETs in vernünftigen Grenzen gehalten werden. Für eine Nutzung des Tastverhältnisses $V_T$ über 50 % hinaus bis 100 % ist jedoch bei geforderter galvanischer Trennung z.B. eine Übertragung der Steuersignale über Lichtleitkabel mit entsprechender schalterseitigen Empfängerschaltung erforderlich.

In FIG. 9 ist beispielhaft eine Gruppe von vier in Reihe geschalteten MOSFETs 10-40 gezeigt, von denen nur der MOSFET 10 über eine Steuerleitung ST 10 direkt angesteuert wird, während die Ansteuerung der übrigen MOSFET 20-40 über einen RC-Spannungsteiler R50-R80, C20-C40 erfolgt. Der MOSFET 10 liegt dabei dem Minus-Bezugspotential der Reihenschaltung am Punkt P10 am nächsten, während der MOSFET 40 dem Plus-Bezugspotential der Reihenschaltung am Punkt P20 am nächsten liegt. Zur Strombegrenzung werden die Gate-Elektroden der einzelnen MOSFETs 10-40 jeweils an einen Strombegrenzungswiderstand R10-R40 angeschlossen. Außerdem sind Zenerdioden Z10-Z40 vorgesehen, die jeweils die Source-Elektrode des zugeordneten MOSFETs 10-40 mit dessen Gate-Elektrode verbinden.

Der RC-Spannungsteiler besteht aus einer Reihenschaltung von vorzugsweise gleichen Widerständen R50-R80 und aus einer Parallelschaltung von Kondensatoren C20-C40, die mit ihrem einen Ende jeweils an das Minus-Bezugspotential der MOSFET-Reihenschaltung angeschlossen sind und mit ihrem anderen Ende jeweils an einen der Verbindungspunkte P11-P13 zwischen den Widerständen R50-R80 des RC-Spannungsteilers. Die Kapazitäten der Kondensatoren bestimmen sich dabei gemäß der Gleichung
$$C_n = \frac{1}{n} \cdot C_1 \text{ mit } n = 1, 2... \quad (2)$$
wobei $C_1$ die Kapazität des Kondensators C20 ist, $C_2$ die des Kondensators C30 und $C_3$ die des Kondensators C40.

An den beiden Enden der Widerstands-Reihenschaltung R50-R80 ist jeweils eine Hilfsspannungsquelle B1 und B2 mit ihrem positiven Pol angeschlossen, während der negative Pol der Hilfsspannungsquelle B1 an das Minus-Bezugspotential P10 und der der Hilfsspannungsquelle B2 an das Plus-Bezugspotential P20 der MOSFET-Reihenschaltung angeschlossen sind.

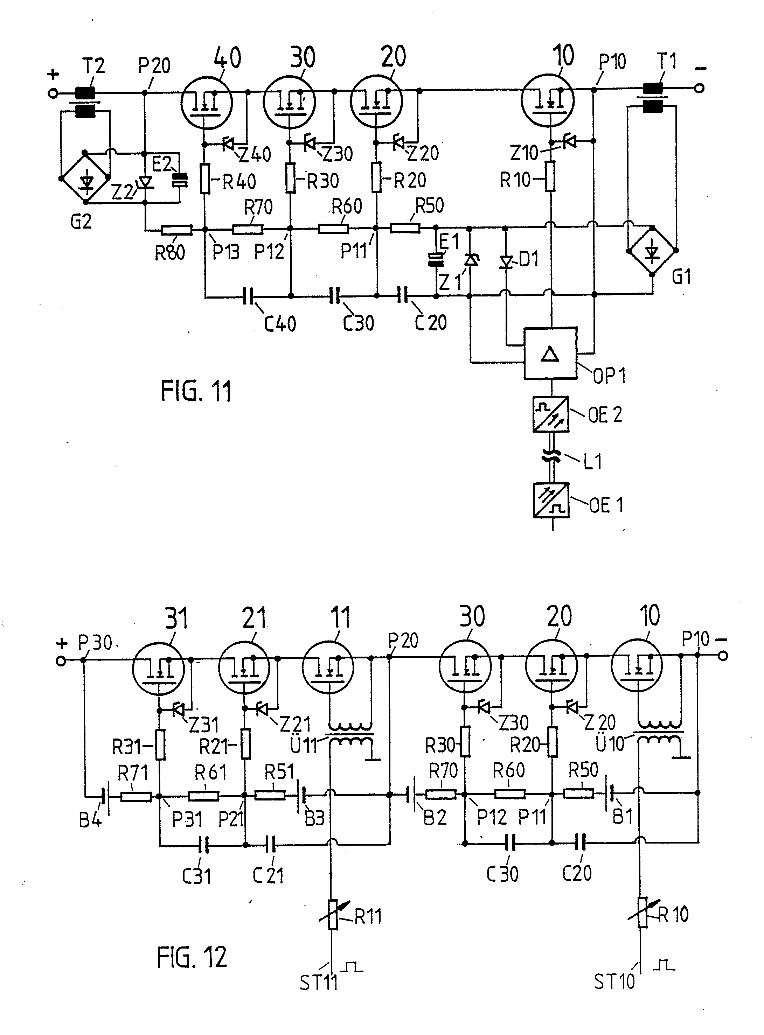

In FIG. 10 ist eine zur Schaltung in FIG. 9 äquivalente Schaltung gezeigt, deren einziger Unterschied darin besteht, daß anstelle der parallel geschalteten Kondensatoren der FIG. 12 nunmehr eine Reihenschaltung von Kondensatoren C20-C40 vorgesehen ist, deren Kapazitäten sich gemäß der Gleichung
$$C_n = n \cdot C_1 \text{ mit } n = 1, 2... \quad (3)$$
bestimmen, wobei $C_1$ die Kapazität des Kondensators C40, $C_2$ die des Kondensators C30 und $C_3$ die des Kondensators C10 ist.

Die beiden Hilfsspannungsquellen B1 und B2 sind erforderlich, um eine möglichst niedrige Restspannung an den durchgeschalteten MOSFETs 10-40 zu erreichen. Die Durchlaß spannung eines MOSFETs beträgt typisch weniger als 6V. Die dafür erforderliche Gate-Spannung beträgt aber typisch 10V. Ohne Hilfsspannungsquellen würde sich statisch eine Restspannung an jeden MOSFET 10-40 in Höhe der erforderlichen Gate-Spannung, also 10V, einstellen. Mit zwei 10V-Hilfsspannungsquellen dagegen ist die Restspannung statisch nur abhängig vom Strom und vom Durchlaßwiderstand $R^{ON}$ der MOSFETs 10-40.

Die statische Aufteilung der Sperrspannung ist abhängig von den Widerständen R50-R80 des RC-Spannungsteilers. Besteht der Spannungsteiler aus gleichen Widerständen R50-R80 und sind die Sperrwiderstände der MOSFETs 10-40 hoch, dann ist die Sperrspannungsaufteilung an den MOSFETs 10-40 im Idealfall gleich.

Weist ein MOSFET, z.B. MOSFET 20 in FIG. 9, einen niedrigen Sperrwiderstand auf oder ist durchlegiert, dann nimmt die Sperrspannung des fehlerhaften MOSFETs 20 und die der potentialmäßig darüber liegenden MOSFETs 30 und 40 ab. Im Extremfall teilt sich die Sperrspannung nur über die potentialmäßig darunter liegenden MOSFETs (hier also MOSFET 10) auf, was zu einer Zerstörung der Bauelemente führen kann.

Da bei der Zerstörung eines MOSFETs auch der Gate-Anschluß eine niederohmige Verbindung zum Drain- und Source-Anschluß des Bauelements aufweist, kann die Gate-Source-Spannung nicht umgepolt werden und es besteht keine Möglichkeit, bei Drain-Source-Kurzschluß eines MOSFETs durch Messung und Auswertung der Gate-Spannung die potentialmäßig darüber liegenden MOSFETs durch Kurzschluß des zugehörigen Widerstands im Spannungsteiler sperrfähig zu machen.

Um einen MOSFET schnell ein- und ausschalten zu können, müssen entsprechend schnell die Kapazitäten $C^{GS}$ und $C_{GD}$ umgeladen werden. Die Gate-Spannung ändert sich dabei aber nur in dem Bereich, der zur vollständigen Einschaltung oder Sperrung des Bauelements erforderlich ist (z.B. 5-10V). In diesem Spannungsbereich ist die Kapazität $C_{GS}$ aber bedeutend größer als üblicherweise im Datenblatt eines solchen MOSFETs für $U_{GS} = 0V$ angegeben. Darüber darüber hinaus ist die Kapazität $C_{GD}$ eines MOSFETs spannungsabhängig. Zwar kann ein MOSFET mit relativ geringem Steuerstrom eingeschaltet werden, um jedoch die in dem Datenblatt des Bauelements spezifizierten Restspannung zu erreichen, muß der Steuerstrom i.a. um mehr als 50 % erhöht werden.

Das Auf- und Entladen der Kapazitäten $C_{GS}$ und $C_{GD}$ eines MOSFETs erfolgt durch einen nach Minus-Bezugspotential geschalteten äußeren Kondensator. Wird der Stromfluß zum Minus-Bezugspotential unterbrochen, dann fließt der Strom über $C_{GD}$ und $C_{GS}$ zu dem äußeren Kondensator, dessen Kapazität dabei so gewählt sein muß, daß eine ausreichende Umladung von $C_{GD}$ und $C_{GS}$ möglich ist.

Diesem äußeren Kondensator entsprechen in den Figuren 9 und 10 die Kondensatoren C20-C40. Wird in diesen Ausführungsbeispielen der potentialmäßig dem Minus-Bezugspotential P10 am nächsten liegende MOSFET 10 durch einen über die Steuer leitung ST10 übertragenen Steuerimpuls von der externen Steuerschaltung (S in FIG. 1) eingeschaltet, dann fließt der Strom aus den äußeren Kondensatoren C20-C40 des RC-Spannungsteilers über die Transistor-Kapazitäten $C_{GS}$ und $C_{GD}$ der übrigen MOSFETs 20-40 der MOSFET-Reihenschaltung und schaltet dadurch die gesamte MOSFET-Kette 10-40 ein.

Nach der Gleichung (2) bzw. (3) ist die Kapazität der Kondensatoren C20-C40 davon abhängig, mit welchen der MOSFETs 10-40 sie verbunden sind und wie sie gegen das Minus-Bezugspotential P10 der Transistorkette geschaltet sind. Die Funktion der beiden Schaltungen in FIG. 9 und 10 ist im übrigen gleich. Eine vorteilhafte Ausführungsform der Schaltung gemäß FIG. 10 ist in FIG. 11 gezeigt.

Die an dem Plus-Bezugspotential P20 angeschlossene Hilfsspannungsquelle B2 der FIG. 10 ist in FIG. 11 in Form eines Stromwandlers T2 mit nachgeschalteter Gleichrichteranordnung G2 realisiert, der eine mit einem Kondensator E2 überbrückte Zenerdiode Z2 nachgeschaltet ist.

Die an dem Minus-Bezugspotential P10 angeschlossene Hilfsspannungsquelle B1 ist ebenfalls in Form einer Zenerdiode Z1 realisiert, die durch einen Kondensator E1 überbrückt ist. Da in diesem Ausführungsbeispiel die Ansteuerung des potentialmäßig dem Minus-Bezugspotential P10 am nächsten liegenden MOSFET 10 potentialfrei erfolgt (hier beispielhaft über ein Lichtleitkabel L1 mit vor- und nachgeschaltetem elektrooptischen Wandler OE1 und OE2), kann die Betriebsspannung für den Steuerbaustein OP1 nur anfangs aus dieser unteren Hilfsspannungsquelle Z1, E1 entnommen werden, die bei Anlegen der zu schaltenden Hochspannung wirksam wird, so daß ein Schalten der MOSFET-Reihenschaltung 10-40 kurzzeitig möglich ist. Die weitere Versorgung erfolgt dann über einen Stromwandler T1 mit nachgeschalteter Gleichrichteranordnung G1.

Der Vorteil einer solchen Schaltung ist vor allem in dem geringen Aufwand für die Ansteuerung zu sehen, da mehrere MOSFET (20-40 in FIG. 9-11) von einem einzigen MOSFET (10 in FIG. 9-11) gesteuert werden, wodurch sich der Schaltungsaufwand für den erfindungsgemäßen Hochspannungsschalter erheblich verringert. In der Praxis ist die Anzahl der in Reihe schaltbaren MOSFETs mit den derzeit erhältlichen Bauelementen ohne zusätzlichen Aufwand (z.B. in Form von Treiberschaltungen) auf ca. 10-15 beschränkt, weil sonst die Summe der Steuerströme größer wird als der zu schaltende Drain-Strom.

Insgesamt sind mit den in den Figuren 8-11 gezeigten Ausführungsbeispielen der erfindungsgemäßen Ansteuerung von Gruppen von in Reihe geschalteten MOSFETs in etwa gleiche Schaltzeiten realisierbar, so daß die in diesen Beispielen beschriebenen unterschiedlichen Arten der Ansteuerung vorteilhaft ohne weiteres miteinander kombiniert werden können, wie das das Ausführungsbeispiel in FIG. 12 zeigt.

Dort sind beispielhaft zwei hintereinandergeschaltete Gruppen von jeweils drei in Reihe geschalteten MOSFETs 10-30 bzw. 11-31 gezeigt, von denen jeweils der potentialmäßig dem Minus-Bezugspotential P10 bzw. P20 der jeweiligen Gruppe am nächsten liegende MOSFET 10 bzw. 11 über eine Steuerleitung ST10 bzw. ST11 von der (nicht gezeigten) externen Steuerschaltung (S in FIG. 1) angesteuert wird. In den beiden Steuerleitungen ist jeweils ein Impulsübertrager Ü10 bzw. Ü11 zur galvanischen Trennung, ein in seinem Wert variabel einstellbarer Widerstand R10 bzw. R11 und gegebenenfalls auch ein (nicht gezeigtes) Zeitverzögerungsglied enthalten, so daß dieser Teil der Schaltung vergleichbar ist mit der Ansteuerung eines MOSFETs in der Schaltung gemäß FIG. 8. Die übrigen MOSFETs 20-30 bzw. 21-31 der beiden Gruppen werden jedoch wie in den Schaltungen gemäß FIG. 10 und 11 jeweils über einen RC-Spannungsteiler angesteuert.

Zur Realisierung eines 30-kV-Hochspannungsschalters müssen unter Berücksichtigung eines ausreichenden Sicherheitsfaktors etwa 60-70 800-V-MOSFET in Reihe geschaltet werden. Mit der erfindungsgemäßen Ansteuerung können diese MOSFETs in 6-7 Gruppen mit jeweils 10 MOSFETs unterteilt werden, von denen jeweils 9 durch einen RC-Spannungsteiler angesteuert werden, während der potentialmäßig jeweils am niedrigsten liegende MOSFET jeder Gruppe über Lichtleitkabel, Trägerfrequenz oder mit Nadelimpulsen von der externen Steuerschaltung (S in FIG. 1) angesteuert wird, so daß insgesamt nur sieben Steuerkanäle für siebzig MOSFET benötigt werden.

Aus Gründen der Sicherheit und Zuverlässigkeit ist es von Vorteil, die Funktionsfähigkeit der Hochspannungsschalter während des Betriebs fortlaufend zu überwachen, um bei einer Fehlfunktion sofort entsprechende Sicherungsmaßnahmen ergreifen zu können.

Erfindungsgemäß wird hierzu der potentialmäßig am höchsten liegende MOSFET jeder Gruppe auf seinen Schaltzustand hin überwacht, da bei Ausfall eines MOSFETs innerhalb dieser Gruppe dieser MOSFET immer mit betroffen ist.

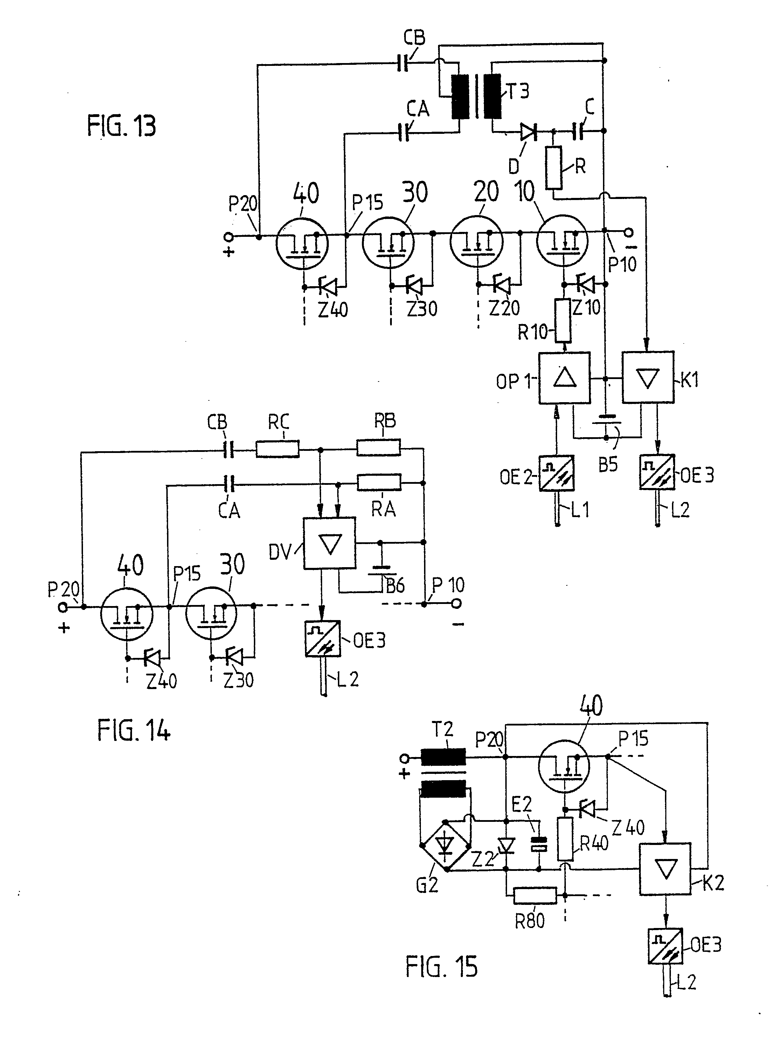

Ausführungsbeispiele von solchermaßen in die einzelnen Gruppen integrierter Überwachungseinrichtungen sind in den Figuren 13 bis 15 gezeigt.

FIG. 13 zeigt eine zu überwachende Gruppe von vier in Reihe geschalteten MOSFET 10-40, deren (nicht vollständig gezeigte) Ansteuerung beispielsweise der Ansteuerung gemäß FIG. 11 entspricht und u.a. ein Lichtleitkabel L1 mit nachgeschalteten elektrooptischem Wandler O E 2 zur Übertragung der Steuerimpulse enthält sowie einen Steuerbaustein OP1, der über einen Strombegrenzungswiderstand R10 an die Gate-Elektrode des dem Minus-Bezugspotential P10 am nächsten liegenden MOSFET 10 angeschlossen ist und der durch eine Hilfsspannungsquelle B5 versorgt wird.

Die erfindungsgemäße Überwachungseinrichtung ist mit jeweils einem ihrer beiden Eingänge an den Anschlußpunkten P20 bzw. P15 an die Drain- bzw. Source-Elektrode des potentialmäßig dem Plus-Bezugspotential am nächsten liegenden MOSFET 40 angeschlossen. Die Eingänge sind über Kondensatoren CA bzw. CB mit den Enden der Primärwicklung eines Übertragers T3 verbunden, dessen Mittenabgriff mit dem Minus-Bezugspotential P10 der MOSFET-Reihenschaltung verbunden ist. Die Sekundärwicklung des Übertragers T3 ist mit ihrem einem Ende direkt und mit ihrem anderem Ende über eine Reihenschaltung aus Diode D und Kondensator C ebenfalls mit dem Minus-Bezugspotential P10 verbunden. Zwischen Diode D und Kondensator C ist ein Abgriff vorgesehen, der über einen Widerstand R mit einem Komparator K1 verbunden ist, der ebenfalls durch die Hilfsspannungsquelle B5 versorgt wird.

Der Komparator K1 ist ausgangsseitig mit einem elektrooptischen Wandler OE3 verbunden, dessen Ausgang über ein zweites Lichtleitkabel L2 mit einer (nicht gezeigten) Auswerteeinheit in der Steuerschaltung (S in FIG. 1) verbunden ist

Die erfindungsgemäße Überwachungseinrichtung in FIG. 14 unterscheidet sich von der Einrichtung in FIG. 13 dadurch, daß der Kondensator CB über eine Widerstands-Reihenschaltung RB, RC und der Kondensator CA über einen Widerstand RA mit dem Minus-Bezugspotential P10 der MOSFET-Reihenschaltung verbunden ist. Zwischen dem Kondensator CA und dem Widerstand RA sowie zwischen den beiden Widerständen RB und RC sind Abgriffe vorgesehen, die mit den Eingängen eines Differenzverstärkers DV verbunden sind, der durch eine Hilfsspannungsquelle B6 versorgt wird. Ausgangsseitig ist der Differenzverstärker DV wieder mit einem elektrooptischem Wandler OE3 verbunden, dessen Ausgang über ein zweites Lichtleitkabel mit der (nicht gezeigten) Auswerteeinheit verbunden ist.

Eine dritte Ausführungsform der erfindungsgemäßen Überwachungseinrichtung ist in FIG. 15 gezeigt. Sie besteht im wesentlichen aus einem Komparator K2, der eingangsseitig an die Source-Elektrode des dem Plus-Bezugspotenital P20 der MOSFET-Reihenschaltung potentialmäßig am nächsten liegenden MOSFET 40 angeschlossen ist und der durch die in FIG. 11 detailiert gezeigte Hilfsspannungsquelle B2 versorgt wird, die in Form eines Stromwandlers T2 mit nachgeschalteter Gleichrichteranordnung G2 der eine mit einem (Elko-)Kondensator E2 überbrückte Zenerdiode Z2 nachgeschaltet ist, realisiert ist.

Ausgangsseitig ist der Komparator K2 wieder mit einem elektrooptischem Wandler OE3 verbunden, dessen Ausgang über ein zweites Lichtleitkabel L2 mit der (nicht gezeigten) Auswerteeinheit verbunden ist.

Bei den erfindungsgemäßen Ansteuerungen gemäß FIG. 9-11 mit einem RC-Spannungsteiler R50-R80, C20-C40, ist eine einwandfreie Sperrung der Transistoren und eine damit verbundene angenähert gleiche Sperrspannungsaufteilung bei den in Reihe geschalteten MOSFETs 10-40 nur gegeben, wenn der Sperrwiderstand (Drain-Source) jedes Transistors 10-40 bedeutend höher ist als der Widerstandswert des RC-Spannungsteilers R50-R80, C20-C40. Ist dies nicht der Fall oder ist im Extremfall ein beliebiger Transistor der MOSFET-Reihenschaltung durchlegiert, dann ist die am obersten Transistor der Kette beim Schalten meßbare Wechselspannung bedeutend niedriger als normal. Diese Spannung wird durch Messung gegen das Minus-Bezugspotential P10 der Kette und Differenzbildung ausgewertet. Sind in FIG. 13 die Kondensatoren $C_A$ und $C_B$ gleichgroß, dann heben sich bei Ausfall eines Transistors die über die Kondensatoren (CA bzw. CB) fließenden Ströme im Übertrager T3 auf und die sekundärseitige Spannung ist null. In der Praxis nimmt die Spannung um ca. 30-50 % ab. In FIG. 14 wird die am Drainanschluß des obersten Transistors 40 gemessene Spannung hinter dem Kondensator CB derart geteilt, daß zwischen RB und RC eine Spannung meßbar ist, die dem Wert entspricht, der sich bei Messung der Drainspannung des vorletzten Transistors 30 hinter dem Kondensator CA an RA einstellt. Im Idealfall ist die Differenzspannung null. Bei Ausfall eines Transistors in der MOSFET-Reihenschaltung ist die Differenzspannung ungleich null und der angeschlossenen Differenzverstärker DV kann eine Fehlermeldung abgeben, die , wie in FIG. 13, über den elektrooptischen Wandler OE3 und das Lichtleitkabel L2 (oder alternativ hierzu über einen Impulsübertrager mittels Trägerfrequenz) zur Auswerteeinheit in der Steuerschaltung z.B. auf Erdpotential übertragen wird.

In FIG. 15 wird die Schaltspannung des obersten Transistors 40 direkt von einem Komperator K2 ausgewertet, der bei Unterschreitung einer Schwelle eine zu kleine Schaltspannung z.B. über den elektrooptischen Wandler OE3 und Lichtleitkabel L2 (oder alternativ hierzu über einen Impulsübertrager mittels Trägerfrequenz ) der Auswerteeinheit in der Steuerschaltung meldet.

Die Überwachungsschaltungen für die einzelnen MOSFET-Gruppen können jeweils von der gleichen Hilfsspannungsquelle (B1 in den Figuren 9 und 10) versorgt werden, mit der auch der Signalempfänger (OP1 in FIG. 11) zur Ansteuerung des potentialmäß am niedrigsten liegenden MOSFET (10 in den Figuren 10-12) betrieben wird.

Die Hilfsspannungsquelle kann dabei - wie weiter oben diskutiert - beim Einschalten aus dem Widerstandteiler gespeist werden und anschließend aus einem Stromwandler. Die ·Fehlerrückmeldung kann zur weiteren Auswertung z.B. über Lichtleitkabel, Trägerfrequenz oder Impulsübertrager nach Erdpotential übertragen werden.

Es versteht sich, daß die Erfindung mit fachmännischem Können aus- und weitergebildet werden kann bzw. an die unterschiedlichen Anwendungen angepaßt werden kann, ohne daß dies hier näher erläutert werden muß.

So ist es z.B. denkbar, zur Übertragung der Steuerimpulse und der Fehlerrückmeldungsignale jeweils ein gemeinsames Lichtleitkabel vorzusehen, an dessen Enden jeweils ein Sender und Empfänger angeordnet ist, wobei vorzugsweise unterschiedliche Lichtwellenlängen für die Übertragung der Steuerimpulse einerseits und der Fehlerrückmeldungssignale andererseits verwendet werden.

Weiterhin ist es von Vorteil, bei der Festlegung der Anzahl der erforderlichen Gruppen Redundanz vorzusehen, so daß der Hochspannungsschalter auch bei Ausfall einer Gruppe weiter betrieben werden kann, da i.a. bei Ausfall eines MOSFET dieser niederohmig, d.h. leitend wird und nicht hochohmig, d.h. sperrend, so daß der Stromfluß hierdurch nicht unterbrochen wird.

Schließlich ist es denkbar, die Steuerung der MOSFETs bzw. die Auswertung der Fehlerrückmeldungssignale von einem Mikroprozessor o.ä.

durchführen zu lassen.

Der erfindungsgemäße Schalter kann allgemein dort eingesetzt werden, wo hohe Gleichspannungen ein- und ausgeschaltet werden müssen. Er eignet sich insbesondere für den Einsatz in all den Anwendungen, bei denen bislang teure und verschleißbehaftete Schaltröhren, insbesondere Hochleistungs-Schaltröhren verwendet werden mußten.

Beispiele hierfür sind Hochspannungs-Gleichstromversorgungen, insbesondere für die Stromversorgung von Magneten in Teilchenbeschleunigeranlagen oder Modulationsverstärker für Sender, insbesondere Modulationsverstärker für amplitudenmodulierte Hochleistungssender des Lang-, Mittel- und Kurzwellenbereichs, deren RF-Endstufe auch heute noch mit einer zumeist anodenmodulierten RF-Leistungsröhre ausgerüstet sind, für die Modulationsspannungen bis zu 30-50 KV benötigt werden.

Ein solcher Modulationsverstärker besteht aus einem Schaltverstärker und einem Tiefpaßfilter. Der Schaltverstärker wird durch eine Folge von Impulsen angesteuert, die aus dem modulierenden analogen Niederfrequenz-Eingangssignal abgeleitet werden. Je nach Art des Steuerverfahrens ist dabei die Impuls- oder Schaltfrequenz, d.h. die Anzahl der Impulse pro Zeiteinheit, bei konstanter Impulsdauer und -amplitude proportional zur Amplitude des Eingangssignals ·oder die Impulsdauer bei konstanter Impulsfrequenz und -amplitude. Im ersten Fall spricht man von der Pulsfrequenzmodulation (PFM) und im zweiten Fall von der Pulsdauermodulation (PDM) wobei in der Praxis der PDM i.a. der Vorzug gegeben wird, u.a. wegen der in der Regel besseren Filterung (z.B. Polstellen).

Ein solcher, beispielsweise mit pulsdauermodulierten Impulsen angesteuerter Modulationsverstärker ("Pulsdauermodulationsverstärker" oder kurz "PDM-Verstärker") ist aufgrund seines Schaltungsprinzips nur in der Lage, eine Ausgangsspannung $U_A$ an das RF-Teil abzugeben, die kleiner als die Eingangsspannung $U_B$ ist. Der Einstellbereich liegt zwischen 0 und 100 % der Eingangsspannung $U_B$, wobei jeder beliebige Wert von $U_A$ zwischen 0 und 100 % von $U_B$ statisch oder dynamisch eingestellt werden kann. Somit hat der Modulationsverstärker eine untere Grenzfrequenz von 0 Hz und damit die Eigenschaft eines Gleichspannungstransformators.

Da der Modulationsverstärker sowohl die Trägerleistung als auch die Modulationsleistung für den RF-Teil des amplitudenmodulierten Senders liefert, muß seine Eingangsspannung $U_B$ gleich der maximalen Anodenspannung der anodenmodulierten RF-Endstufenröhre im RF-Teil sein. Die hohen Anforderungen an einen solchen Verstärker hinsichtlich seiner Ausgangswerte (Leistung, Spannung, Strom etc.) und seiner Qualitäts werte (Klirrfaktor etc.) sowie seines Wirkungsgrades erzwangen bisher den Einsatz einer Schaltröhre.

Diese Schaltröhre kann vorteilhaft durch den erfindungsgemäßen Hochspannungsschalter ersetzt werden. Zum einen vereinfacht sich der Aufbau des Modulationsverstärkers, zum anderen erhöht sich seine Zuverlässigkeit durch die Verwendung von Halbleiterschaltern anstelle der verschleißbehafteten Schaltröhre. Außerdem verringern sich die Ersatzteil- und Wertungskosten, da der (i.a. jährliche) Austausch der Schaltröhre entfällt.

Die zumindest in Kurzwellensendern auch in Zukunft benötigte Röhre für die RF-Endstufe kann bei der erfindungsgemäßen Lösung nunmehr rein nach RF-Gesichtspunkten ausgewählt werden. Es braucht nicht mehr eine Röhre verwendet werden, die auch den Anforderungen im Modulationsverstärker gerecht wird.

Ferner entfallen bei einem Modulationsverstärker mit dem erfindungsgemäßen Hochspannungsschalter der Heiztransformator, das Schirmgitternetzgerät sowie die aufwendige Treiberstufe für die Schaltröhre, was mit einer entsprechenden Kostenersparnis bei der Herstellung verbunden ist. Eine weitere erhebliche Kostenersparnis kommt dadurch zustande, daß anstelle der bisher üblicherweise als Filterdrossel in dem Tiefpaßfilter des Modulationsverstärkers verwendeten aufwendigen Speicherspule mit zwei Wicklungen nunmehr eine herkömmliche Speicherdrossel mit nur einer Wicklung verwendet werden kann.

Schließlich ergibt sich ein weiterer Vorteil aus der Möglichkeit, daß die insbesondere bei Sendern kleinerer Leistung (100 kW und weniger) bei sehr schmalen PDM-Impulsen auftretenden "Unterstrichverzerrungen" durch den Einbau eines zweiten erfindungsgemäßen Halbleiterschalters parallel zur Freilaufdiode beseitigt werden können, der im Gegentakt zum Hauptschalter arbeitet. Der Wirkungsgrad wird hierdurch nur unmerklich verschlechtert, da der Strom bei Oberstrich und Träger (d.h. also bei hohen Stromwerten) wegen der kurzen Entladezeiten (die i.a. kürzer sind als die Totzeiten zwischen den Schaltvorgängen der beiden Schalter) über die Speicherdrossel weiterfließt und im Lastwiderstand verbraucht wird und nur bei Unterstrich (d.h. also bei kleinen Stromwerten bzw. bei größeren Entladezeiten) über den zweiten Schalter umgelenkt wird und in einem in Reihe mit dem zweiten Schalter liegenden Widerstand verbraucht wird. Zur Optimierung ist es möglich, die Totzeiten zwischen den Schaltvorgängen der beiden Schalter stromabhängig variabel zu machen, so daß der Zusatzschalter mit Halbleiter-Schaltern kleinerer Schaltleistung aufgebaut werden kann, die i.a. kürzere Schaltzeiten aufweisen, so daß dadurch die Verluste in dem Zusatzschalter noch weiter verringert werden können.

Diese Schaltungsmöglichkeit bestand bei der bekannten Lösung mit Röhren aus wirtschaftlicher Sicht nicht, da zusätzlich ein Heizungstransformator, ein Schirmgitternetzgerät sowie eine Treiberstufe hätten eingebaut werden müssen. Bei der bekannten Lösung hat man daher durch entsprechende steuerungstechnische Maßnahmen bei Unterstrich, d.h. bei kurzen Schaltimpulsen, die Röhre nicht mehr voll eingeschaltet und dadurch nicht mehr als Schalter, sondern als veränderlicher Widerstand betrieben, was jedoch mit einer entsprechenden Verschlechterung des Wirkungsgrades einherging.

## Ansprüche

1. Hochspannungsschalter mit mehreren in Reihe geschalteten und mit Steuerimpulsen einer Steuerschaltung synchron angesteuerten Halbleiterschaltern, welche Steuerschaltung mehrere Steuerleitungen zur Übertragung der Steuerimpulse zu den Halbleiterschaltern aufweist und galvanisch von den Halbleiterschaltern getrennt ist, dadurch gekennzeichnet, daß die Halbleiterschalter (10-4N) in Gruppen (10, 20, 30, 40; 11, 21, 31, 41;...; 1N, 2N, 3N, 4N) zusammengefaßt sind und daß zu jeder Gruppe (10, 20, 30, 40; 11, 21, 31, 41; ....; 1N, 2N, 3N, 4N) jeweils nur eine Steuerleitung (ST10; ST11;....; ST1N) führt (FIG. 1).

2. Hochspannungsschalter nach Anspruch 1, dadurch gekennzeichnet, daß die einzelnen Steuerleitungen (ST10; ST11;...; ST1N) jeweils einen Impulsübertrager zur galvanischen Trennung aufweisen.

3. Hochspannungsschalter nach Anspruch 1 dadurch gekennzeichnet, daß die einzelnen Steuerleitungen (ST10; ST11;...; ST1N) zur galvanischen Trennung jeweils einen aus einem Lichtleitkabel bestehenden Abschnitt enthalten und daß an den beiden Enden eines solchen Lichtleitkabels jeweils ein elektrooptischer Wandler vorgesehen ist.

4. Hochspannungsschalter nach einem der Ansprüche 1 bis 3, dadurch gekennzeichnet, daß die einzelnen Halbleiterschalter (10-4N) jeweils Static-Induction-Transistoren sind.

5. Hochspannungsschalter nach einem der Ansprüche 1 bis 3, dadurch gekennzeichnet, daß die einzelnen Halbleiterschalter (10-4N) jeweils MOS-Feldeffekttransistoren (MOSFET) sind.

6. Hochspannungsschalter nach einem der Ansprüche 1 bis 3 und Anspruch 5, dadurch gekennzeichnet, daß die zu den einzelnen Gruppen führenden Steuerleitungen (ST10) jeweils mit der Gate-Elektrode des dem Minus-Bezugspotential (P10) der MOSFET-Reihenschaltung (10-40) potentialmäßig am nächsten liegenden ersten MOSFETs der MOSFET-Reihenschaltung (10-40) der ihnen jeweils zugeordneten Gruppe verbunden sind und daß die Steuerung der übrigen MOSFETs (20-40) dieser MOSFET-Reihenschaltung (10-40) jeweils über einen RC-Spannungsteiler (R50-R80, C20-C40) erfolgt (FIG. 9, FIG. 10).

7. Hochspannungsschalter nach Anspruch 6, dadurch gekennzeichnet, daß für den Fall der galvanischen Trennung von Steuerschaltung und Hochspannungsschalter durch Impulsübertrager in den einzelnen Steuerleitungen die Impulsübertrager (Ü10; Ü11) in den zu den einzelnen Gruppen (10-30; 11-31) führenden Steuerleitungen (ST10; ST11) jeweils mit dem einen Ende ihrer Sekundärwicklung an die Gate-Elektrode und mit dem anderen Ende ihrer Sekundärwicklung an die Source-Elektrode des ersten MOSFETs (10, 11) der ihnen jeweils zugeordneten Gruppe (10-30; 11-31) angeschlossen sind und mit dem einen Ende ihrer Primärwicklung an Masse und mit dem anderen Ende ihrer Primärwicklung an die Steuerschaltung angeschlossen sind (FIG. 12).

8. Hochspannungsschalter nach Anspruch 7, dadurch gekennzeichnet, daß zur Einstellung der Sperrspannungsaufteilung zwischen den einzelnen Gruppen (10-30; 11-31) in den einzelnen Steuerleitungen (ST10; ST11) jeweils zwischen Steuerschaltung und Impulsübertrager (Ü10; Ü11) ein in seinem Wert variabel einstellbarer Widerstand (R10; R11) vorgesehen ist (FIG. 12).

9. Hochspannungsschalter nach einem der Ansprüche 6 bis 8, dadurch gekennzeichnet, daß zur Synchronisierung der Schaltzeitpunkte der einzelnen Gruppen (10-30; 11-31) in den einzelnen Steuerleitungen (ST10; ST11) jeweils ein variabel einstellbares Zeitverzögerungsglied vorgesehen ist.

10. Hochspannungsschalter nach einem der Ansprüche 6 bis 9, dadurch gekennzeichnet,
- daß der RC-Spannungsteiler (R50-R80, C20-C40) mehrere in Reihe geschaltete Widerstände (R50-R80) enthält;
- daß die Zahl der Widerstände (R50-R80) der Zahl der in Reihe geschalteten MOSFETs (10-40) entspricht;
- daß die in Reihe geschalteten übrigen MOSFETs (20-40) mit ihren Gate-Elektroden so an die Verbindungspunkte (P11-P13) zwischen den in Reihe geschalteten Widerständen (R50-R80) angeschlossen sind, daß sich zwischen den Gate-Elektroden direkt benachbarter MOSFETs (20, 30; 30, 40) jeweils ein Widerstand (R60; R70) der Widerstands-Reihenschaltung (R50-R80) befindet (FIG. 9, FIG. 10).

11. Hochspannungsschalter nach Anspruch 10, dadurch gekennzeichnet,
- daß an den beiden Enden der Widerstands-Reihenschaltung (R50-R80) jeweils eine Hilfsspannungsquelle (B1; B2) mit ihrem positiven Pol angeschlossen ist;

- daß die eine Hilfsspannungsquelle (B1) mit ihrem negativen Pol an das Minus-Bezugspotential (P10) und die andere Hilfsspannungsquelle (B2) mit ihrem negativen Pol an das Plus-Bezugspotential (P20) der zugehörigen MOSFET-Reihenschaltung (10-40) angeschlossen sind (FIG. 9, FIG. 10).

12. Hochspannungsschalter nach einem der Ansprüche 10 bis 11, dadurch gekennzeichnet,
- daß an den Verbindungspunkten (P11-P13) zwischen den in Reihe geschalteten Widerständen (R50-R80) des RC-Spannungsteilers (R50-R80, C20-C40) jeweils ein einseitig an das Minus-Bezugspotential (P10) der zugehörigen MOSFET-Reihenschaltung (10-40) angeschlossener Kondensator (C20-C40) angeschlossen ist;
- daß die Kapazitäten dieser Kondensatoren (C20-C40), ausgehend von der Kapazität $C_1$ des an den dem Minus-Bezugspotential (P10) am nächsten liegenden Verbindungspunkt (P11) angeschlossenen Kondensators (C20) gemäß der Beziehung $C_n = \frac{1}{n} \cdot C_1$ mit n = 1, 2,...sukzessive abnimmt (FIG. 9).

13. Hochspannungsschalter nach einem der Ansprüche 10 bis 11, dadurch gekennzeichnet,
- daß mit Ausnahme des dem Plus-Bezugspotential (P20) der zugehörigen MOSFET-Reihenschaltung (10-40) am nächsten liegenden Widerstands (R80) den einzelnen Widerständen (R50; R60; R70) der Widerstands-Reihenschaltung (R50-R80) des RC-Spannungsteilers (R50-R80, C20-C40) jeweils ein Kondensator (C20; C30; C40) einer Kondensator-Reihenschaltung (C20-C40) parallel geschaltet ist;
- daß die Kapazitäten dieser Kondensatoren (C20-C40), ausgehend von der Kapazität $C_1$ des an den dem Plus-Bezugspotential (P20) der zugehörigen MOSFET-Reihenschaltung (10-40) am nächsten liegenden Verbindungspunkt (P13) der Widerstand-Reihenschaltung (R50-R80) angeschlossenen Kondensators (C40), gemäß der Beziehung $C_n = n \cdot C_1$ mit n = 1, 2,...sukzessive zunimmt (FIG. 10).

14. Hochspannungsschalter nach einem der Ansprüche 5 bis 13, dadurch gekennzeichnet, daß der Gate-Elektrode eines jeden MOSFETs (10-40) jeweils ein Strombegrenzungswiderstand (R10-R40) vorgeschaltet ist (FIG. 9, FIG. 10, FIG. 11)

15. Hochspannungsschalter nach einem der Ansprüche 1 bis 14, dadurch gekennzeichnet, daß in dem Hochspannungsschalter Einrichtungen zur Überwachung der Schalterfunktion und zur Fehlermeldung an die Steuerschaltung vorgesehen sind und daß vorzugsweise für jede Gruppe von Halbleiterschaltern eine solche Überwachungseinrichtung vorgesehen ist.

16. Hochspannungsschalter nach Anspruch 15, dadurch gekennzeichnet,
- daß eine solche Überwachungseinrichtung für eine Gruppe von Halbleiterschaltern (10-40) einen einen primärseitigen Mittenabgriff aufweisenden Übertrager (T3) aufweist;

- daß die Primärwicklung des Übertragers (T3) mit dem einem Ende über einen zweiten Kondensator (CB) mit dem Plus-Bezugspotential (P20) der Gruppe und mit dem anderem Ende über einen ersten Kondensator (CA) mit dem Verbindungspunkt (P15) zwischen dem potentialmäßig dem Plus-Bezugspotential (P20) am nächsten und dem diesem Bezugspotential (P20) am zweitnächsten liegenden Halbleiterschalter (40 bzw. 30) sowie mit dem Mittenabgriff mit dem Minus-Bezugspotential (P10) der Gruppe verbunden ist;

- daß die Sekundärwicklung des Übertragers (T3) mit dem einem Ende über eine Reihenschaltung aus einer Diode (D) und einem dritten Kondensator (C) und mit dem anderen Ende direkt an das Minus-Bezugspotential (P10) der Gruppe angeschlossen ist;

- daß zwischen Diode (D) und Kondensator (C) ein Abgriff vorgesehen ist und daß dieser Abgriff über einen Widerstand (R) mit dem Eingang eines Komparators (K1) verbunden ist;

- daß der Komparator (K1) ausgangsseitig vorzugsweise über Lichtleitkabel (L2) mit einer Auswerteeinheit in der Steuerschaltung verbunden ist (FIG. 13).

17. Hochspannungsschalter nach Anspruch 15, dadurch gekennzeichnet,

- daß eine solche Überwachungseinrichtung für eine Gruppe von Halbleiterschaltern (10-40) eine erste Reihenschaltung aus erstem Kondensator (CA) und einem ersten Widerstand (RA) und eine zweite Reihenschaltung aus zweitem Kondensator (CB) und einem zweiten und dritten Widerstand (RB, RC) enthält;

- daß die zweite Reihenschaltung (CB, RB, RC) das Plus-Bezugspotential (P20) mit dem Minus-Bezugspotential (P10) der Gruppe verbindet und daß die erste Reihenschaltung (CA, RA) den Verbindungspunkt (P15) zwischen den potentialmäßig dem Plus-Bezugspotential (P20) am nächsten und dem diesem Bezugspotential (P20) am zweitnächsten liegenden Halbleiterschalter (40 bzw. 30) mit dem Minus-Bezugspotential (P10) der Gruppe verbindet;

- daß zwischen erstem Kondensator (CA) und erstem Widerstand (RA) sowie zwischen zweitem und drittem Widerstand (RB, RC) jeweils ein Abgriff vorgesehen ist und daß diese Abgriffe mit den entsprechenden Eingängen eines Differenzverstärkers (DV) verbunden sind;

- daß der Differenzverstärker (DV) ausgangsseitg vorzugsweise über Lichtleitkabel mit der Auswerteeinheit in der Steuerschaltung verbunden ist (FIG. 14)

18. Hochspannungsschalter nach Anspruch 15, dadurch gekennzeichnet,

- daß eine solche Überwachungseinrichtung für eine Gruppe von Halbleiterschaltern (10-40) einen weiteren Komparator (K2) aufweist,

- daß dieser weitere Komparator (K2) die Schaltspannung des dem Plus-Bezugspotential (P20) der Gruppe am nächsten liegenden Halbleiterschalters (40) direkt auswertet und bei Unterschreitung eines vorgegebenen Schwellenwertes ein Fehlersignal vorzugsweise über Lichtleitkabel an die Auswerteeinheit in der Steuerschaltung abgibt.

19. Hochspannungsschaltung nach einem der Ansprüche 1 bis 18, dadurch gekennzeichnet, daß die Steuerschaltung pulsdauermodulierte Steuerimpulse mit konstanter Schaltfrequenz erzeugt.

20. Hochspannungsschaltung nach einem der Ansprüche 1 bis 18, dadurch gekennzeichnet, daß die Steuerschaltung pulsfrequenzmodulierte Steuerimpulse mit konstanter Impulsdauer erzeugt.

21. Hochspannungsschaltung nach einem der Ansprüche 1 bis 20, gekennzeichnet durch die Anwendung als Schalter in einem Modulationsverstärker für Sender, insbesondere in einem pulsdauermodulierten Modulationsverstärker für amplitudenmodulierten Hochleistungssender mit einer anodenmodulierten RF-Endstufenröhre.

22. Hochspannungsschaltung nach einem der Ansprüche 1 bis 20, gekennzeichnet durch die Anwendung als Schalter in einer Hochspannungs-Gleichstromversorgung, insbesondere für die Stromversorgung von Magneten in Teilchenbeschleunigeran lagen.

FIG.1

EP 0 353 406 A1

EP 0 353 406 A1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 526 787  (STOVER)<br>* Spalte 1, Zeilen 25-32; Spalte 5, Zeile 50 - Spalte 7, Zeile 59; Figuren 4-7 * | 1,2,22 | H 03 K 17/10<br>H 03 K 17/08<br>H 03 F 3/217 |
| Y | --- | 19,20 | |
| X | US-A-3 510 687  (TOULEMONDE)<br>* Spalte 1, Zeilen 53-63; Spalte 3, Zeile 64 - Spalte 6, Zeile 54; Figuren 1,2 * | 1,2,22 | |
| Y | | 4-7,10, 11,13-15,18, 21 | |
| X | GB-A-1 269 502  (ENGLISH ELECTRIC CO., LTD)<br>* Seite 1, Zeilen 10-16; Seite 1, Zeile 66 - Seite 2, Zeile 6; Figur *<br>--- | 1,3,22 | |
| Y | DE-A-3 125 242  (K.K. MORITA SEISAKUSHO)<br>* Figur 4 *<br>--- | 4 | RECHERCHIERTE SACHGEBIETE (Int. Cl.5)<br><br>H 03 K<br>H 02 M<br>H 03 F |
| Y | EP-A-0 215 707  (THOMSON-CSF)<br>* Spalte 3, Zeile 49 - Spalte 4, Zeile 55; Figuren 3,4 *<br>--- | 5-7,10, 13 | |
| Y | EP-A-0 140 349  (HITACHI LTD)<br>* Seite 10, Zeile 22 - Seite 11, Zeile 16; Figur 7 *<br>---          -/- | 5,6,10, 11 | |

Der vorliegende Recherchenbericht wurde für alle Patentansprüche erstellt

| Recherchenort | Abschlußdatum der Recherche | Prüfer |
|---|---|---|
| DEN HAAG | 13-10-1989 | CANTARELLI R.J.H. |

EPO FORM 1503 03.82 (P0403)

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 048 758 (INTERNATIONAL RECTIFIER CORP.) * Seite 11, Zeile 34 - Seite 12, Zeile 17; Figur 6 * | 5,6,10, 14 | |
| A | --- | 12 | |
| Y | JP-A-61 102 816 (HITACHI LTD) * Figuren 1,2; Zusammenfassung * & PATENT ABSTRACTS OF JAPAN, band 10, Nr. 283 (E-440)[2339], 26. September 1986 --- | 5,6,10, 15,18 | |
| Y | US-A-3 184 615 (STOVER) * Spalte 1, Zeilen 9-12; Figuren 1,3 * --- | 19,20 | |
| Y | EP-A-0 226 006 (LICENTIA) * Seite 4, Zeile 3 - Seite 5, Zeile 15; Seite 7, Zeilen 17-28; Figuren 1,3 * --- | 19,21 | |
| A | CH-A- 451 315 (BROWN & BOVERI) * Spalte 2, Zeile 28 - Spalte 3, Zeile 17; Figur 2 * ----- | 9 | RECHERCHIERTE SACHGEBIETE (Int. Cl.5) |

Der vorliegende Recherchenbericht wurde für alle Patentansprüche erstellt

| Recherchenort | Abschlußdatum der Recherche | Prüfer |
|---|---|---|
| DEN HAAG | 13-10-1989 | CANTARELLI R.J.H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

 

& : Mitglied der gleichen Patentfamilie, übereinstimmendes Dokument